Europäisches Patentamt

European Patent Office

Office européen des brevets

(19)

(11) Publication number: **0 181 714**
A1

# EUROPEAN PATENT APPLICATION

(12)

(21) Application number: 85307527.3

(22) Date of filing: 18.10.85

(51) Int. Cl.⁴: **H 01 L 21/306**

(30) Priority: 24.10.84 GB 8426915

(43) Date of publication of application:
21.05.86 Bulletin 86/21

(84) Designated Contracting States:
CH DE FR IT LI NL SE

(71) Applicant: MARCONI INSTRUMENTS LIMITED
Longacres Hatfield Road
St. Albans Hertfordshire, AL4 0JN(GB)

(72) Inventor: Sisson, Michael James
5 Lower Mead Iver Heath
Buckinghamshire(GB)

(72) Inventor: Monk, David Graham
34 Rowley Furrows Milebush Estate Linslade
Leighton Buzzard Bedfordshire LU7 7SH(GB)

(74) Representative: Pope, Michael Bertram Wingate
Central Patent Department Wembley Office The General
Electric Company, p.l.c. Hirst Research Centre East Lane
Wembley Middlesex HA9 7PP(GB)

(54) Method of fabrication devices on semiconductor substrates.

(57) A method of fabricating a device on a semiconductor substrate (11 or 21) wherein a structure (5) is formed on a first surface of the substrate (11 or 21) and a selected part of the assembly comprising the substrate (11 or 21) and the structure (5) is subsequently removed by etching from the opposite surface of the substrate is described. The part of the assembly to be etched is defined by doping a region (9 or 23) of the substrate extending into the substrate (11 or 21) from the first surface so as to prevent removal of the region (9 or 23) during etching.

Fig.2.

Fig.3.

Croydon Printing Company Ltd

EP 0 181 714 A1

## Method of fabricating devices on semiconductor substrates

This invention relates to methods of fabricating devices on semiconductor substrates.

In such methods it is frequently necessary to perform processing steps on the surface of the substrate opposite to the surface on which at least part of the structure of the device has already been formed. Examples of such processing steps are the scribing of the substrate to produce separate devices, or the chemical etching of a selected portion or even all of the substrate, this latter process necessarily being performed from the opposite surface for example where beam leads have been provided to the already-formed device structure, such leads extending beyond the substrate in the separated device. In such processing steps it is necessary for the regions processed from the opposite surface of the substrate to be positioned in desired manner with respect to the structure already formed, e.g. by use of an appropriately positioned mask.

With the present trend to diminishing sizes of devices it is becoming increasingly difficult to achieve such alignment.

It is an object of the present invention to provide a method of fabricating devices on a semiconductor substrate whereby this problem may be overcome.

According to the present invention a method of fabricating a device on a semiconductor substrate wherein a structure is formed on a first surface of the substrate and a selected part of the assembly comprising said substrate and structure is subsequently removed by etching from the opposite surface of the substrate is characterised in that the part of the assembly to be etched is defined by doping a region of said substrate extending into said substrate from said first surface so as to prevent removal of said region during etching.

In one particular method in accordance with the invention, the etching process is an anisotropic process, and said region acts as a mask to protect a portion of the assembly between the region and the surface of the structure remote from the first surface during the etching process.

In another particular method in accordance with the invention the etching is effective to remove all the substrate except for said region.

A method in accordance with the invention may also include the step of doping a second region extending through the structure at least as far as the first surface so as to allow removal of said second region during etching.

Two methods of fabricating a device on a semiconductor substrate in accordance with the invention, will now be described, by way of example only, with reference to the accompanying drawings in which:-

Figure 1 is a schematic diagram of a cross section through the device;

Figure 2 illustrates a stage in the first method; and

Figure 3 illustrates a stage in the second method.

In all the figures, the vertical scale has been expanded to more clearly illustrate the device.

In the methods to be described the device has a 'picture frame' structure for use as a semiconductor pressure sensor.

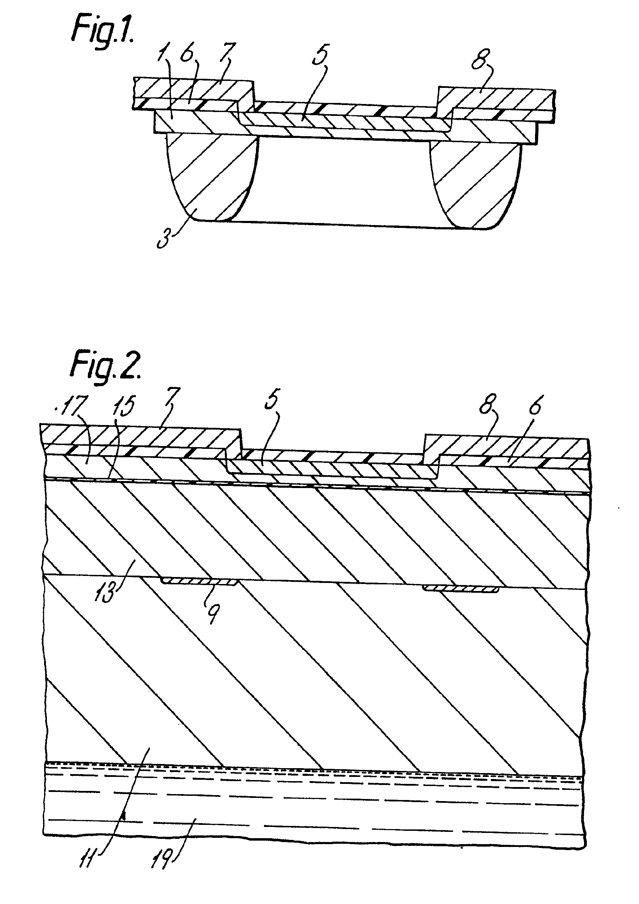

Referring firstly to Figure 1, the device comprises a thin silicon web 1 supported on a rectangular silicon frame 3. Formed in the surface of the web 1 remote from the frame 3 there is a semiconductor structure, indicated generally as 5, including various doped regions, the form of the structure depending on the intended purpose of·the pressure sensor. An insulating layer 6 overlies the web 1. Two beam leads, 7, 8 are also provided which make electrical contact to the structure 5.

Referring now also to Figure 2, in the first method of fabrication to be described, the first step is to diffuse a shallow p+ region 9 in the shape of the rim of the required frame 3 into a (100) oriented silicon substrate 11.A lightly doped n or p-type epitaxial layer 13 is then grown over the surface of the substrate from which the region 9 extends, the layer 13 being of a depth corresponding to the required thickness of the frame 3 in the finished device. A layer of silicon nitride 15 is then deposited over the epitaxial layer 13, a layer of polycrystalline silicon 17 in turn being deposited over the silicon nitride layer 15. The doped regions of the structure 5 are then formed by diffusion in the polycrystalline silicon layer 17, these regions being positioned on the substrate with respect to the region 9 in desired manner, using the buried layer alignment techniques well established in integrated circuit manufacturing technology. The insulating layer 6 is then deposited over the polycrystalline silicon layer 17, and the beam leads 7, 8 formed.

To achieve the required device geometry as shown in Figure 1, an alkaline etchant 19, for example potassium hydroxide or alternatively a solution of pyrocatechol and ethylene diamine, is applied to the surface of the substrate 11 opposite to the surface on which the epitaxial layer 13 has been deposited. The etchant will etch through the substrate 11 until it reaches the p+ region 9, this region acting as an etch stop to the alkaline etchant 19. The etchant will continue to etch through the epitaxial layer 13 up to the silicon nitride layer 15, the region 9 however acting as a mask to protect the portion of the layer 13 lying between the region 9 and the silicon nitride layer 15.

The etchant does not however etch the {111} planes, such that the portion of the layer 13 lying between the region 9 and the silicon nitride layer 15 will remain substantially intact bounded by {111} planes so as to form the frame 3 for the device as shown in Figure 1. A further etching process will however be necessary to remove the peripheral portions of the layers 15, 17, 6 in order to separate out the devices.

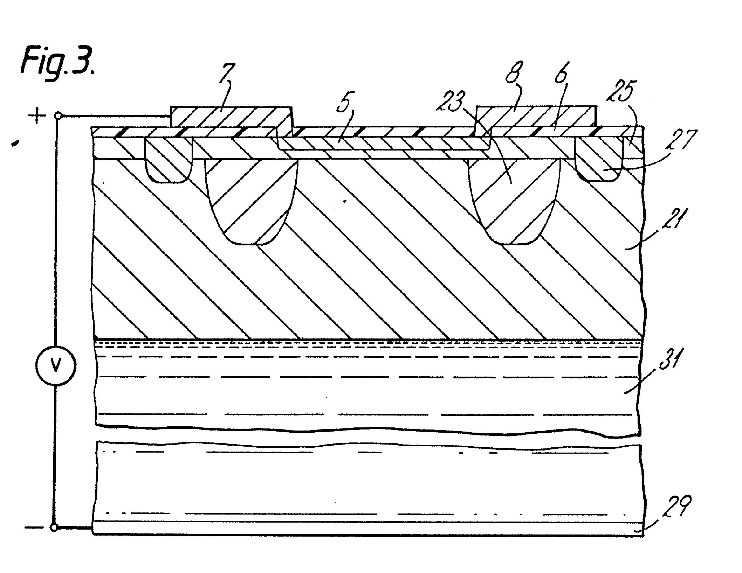

The second method of fabrication will now be explained with reference to Figure 3. Using for example ion beam implantation at a desired position on a p-type substrate 21 a deep n-type annular trough 23 is implanted and diffused into a first surface of the substrate, the trough being dimensioned to later constitute the frame 3. An epitaxial n-type layer 25 is then grown on the first face of the substrate 21. A p-type annular trough 27 surrounding the n-type trough, is then formed in the layer 1, and extending into the substrate 21. Doped semiconductor regions within the structure 5 are then formed in the layer 25, none of the p-type regions extending as far as the underlying substrate, the structure 5 being positioned on the substrate 21 in desired manner with respect to the trough 23. The insulating layer 6 is then deposited over the epitaxial layer 25, and beam leads 7 and 8 formed.

To achieve the required device geometry in this second method, a potential in the order of a volt is applied between the n-type trough 23 together with the n-type layer 25 via an n-type region in the structure 5 and an electrode 29 in an electrochemical etching bath containing potassium hydroxide etchant 31. The etchant 31 is applied to the surface of that substrate 21 opposite to the surface on which the epitaxial layer 25 has been formed. As described in Bell System Technical Journal, Volume 49, No. 3, p.473 (March, 1970), the potential applied to the n-type region within the structure 5 will act to passivate this region, together with the underlying n-type epitaxial layer 25, and the n-type trough 23 during the electrochemical etching process, such that the etchant 31 will etch through the substrate 21 up to the layer 25, removing the p-type trough 27, the n-type epitaxial layer 25 protecting any p-type regions in the structure 5. Thus in the single etching operation, the required device geometry of a web 1 supported by a frame 3 is achieved, together with separation of the device shown in Figure 1 from any other devices which have been formed simultaneously on the same substrate.

It will be appreciated that this second method is equally applicable where the final frame 3 is formed from a p-type region which has been implanted into an n-type substrate, the epitaxial layer 25 then also being p-type, and a potential being applied to a p-type region within the structure 5 in order to passivate the p-type material in the etching process.

It will also be appreciated that in both methods described herebefore as all processing steps which are necessarily carried out in a chosen region of the substrate are performed from the same side of the substrate, the problem of aligning the process to structure on the opposite surface of the substrate does not arise.

It will also be appreciated that in the second method, anisotropic etching is not an essential process, and any crystal orientation substrate may therefore be used. This has the particular advantage of allowing freedom of choice of the cross-sectional dimensions of the frame 3, which are then not restricted by the crystal plane orientation.

It will further be appreciated that whilst the methods described herebefore by way of example relate to the manufacture of a frame structure for use in a semiconductor pressure sensor, the invention is applicable to any fabrication method wherein etching from the one surface of a semiconductor substrate to structure present on the opposite surface of the substrate or separation of a device from adjoining devices on the same semiconductor substrate is required.

CLAIMS

1.    A method of fabricating a device on a semiconductor substrate (11 or 21) wherein a structure (1, 5, 6, 7, 8) is formed on a first surface of the substrate (11 or 21), and a selected part of the assembly comprising the substrate (11 or 21) and structure (1, 5, 6, 7, 8) is subsequently removed by etching from the opposite surface of the substrate characterised in that the part of the assembly to be removed is defined by doping a region (9 or 23) of the substrate extending into the substrate (11 or 21) from said first surface so as to prevent removal of said region (9 or 23) during etching.

2.    A method according to Claim 1 in which the etching process is an anisotropic process, and said region (9) acts as a mask to protect a portion of the assembly between the region (9) and the surface of the structure (1, 5, 6, 7, 8) remote from the first surface during the etching process.

3.    A method according to Claim 2 in which said region (9) is doped to have $p^+$ conductivity, and the etching is carried out using an alkaline etchant.

4.    A method according to Claim 1 in which the etching is effective to remove all the substrate (21) except for said region (23).

5.    A method according to Claim 4 in which said region (23) is in the form of a trough.

6.    A method according to Claim 4 or Claim 5 in which a potential is applied to said region (23) during etching, and the etching is an electrochemical etching process.

7. A method according to any one of the preceding claims including doping a second region (27) extending through the structure (1, 5, 6, 7, 8) at least as far as the first surface so as to allow removal of said second region (27) during etching.

8. A method according to any one of the preceding claims in which the device has a picture frame structure providing mechanical support for the device.

9. A method according to any one of the preceding claims in which beam leads (7, 8) are provided on the device prior to the etching.

10. A device fabricated on a semiconductor substrate by a method according to any one of the preceding claims.

0181714

**Fig.1.**

**Fig.2.**

**Fig.3.**

7    5    23    8    6    25

27

21

31

29

+

V

−

0181714

2/2

European Patent Office

EUROPEAN SEARCH REPORT

0181714

Application number

EP 85 30 7527

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| A | FR-A-2 020 229 (N.V. PHILIPS' GLOEILAMPENFABRIEKEN) * Claims 1-11 * | 1,6 | H 01 L 21/306 |
| A | FR-A-2 277 434 (SIEMENS AG) * Claims 3-8 * | 1 | |
| A | GB-A-1 542 083 (STANDARD TELEPHONES AND CABLES LTD.) * Claims 1-3 * | 1 | |
| D,A | THE BELL SYSTEM TECHNICAL JOURNAL, vol. 49, no. 3, March 1970, pages 473-475, New York, US; H.A. WAGGENER: "Electrochemically controlled thinning of silicon" * Figure 1 * | 1,6 | |
| A | JOURNAL OF ELECTROCHEMICAL SOCIETY, vol. 127, no. 5, May 1980, page 1208, Princeton, US; A. REISMAN et al.: "Anomalous etch structures using ethylenediamine-pyrocatechol-water based etchants and their elimination" | | TECHNICAL FIELDS SEARCHED (Int Cl 4) H 01 L |
| A | US-A-4 372 803 (J.R. GIGANTE) | | |

The present search report has been drawn up for all claims

| Place of search | Date of completion of the search | Examiner |
|---|---|---|
| THE HAGUE | 14-01-1986 | ZOLLFRANK G.O. |